Europäisches Patentamt

European Patent Office

Office européen des brevets

(11) Veröffentlichungsnummer: **0 335 988 B1**

# EUROPÄISCHE PATENTSCHRIFT

(51) Int. Cl.⁵: **H03M 3/02**, H03M 1/60

(45) Veröffentlichungstag der Patentschrift: **23.12.92**

(21) Anmeldenummer: **88105242.7**

(22) Anmeldetag: **31.03.88**

(54) Schaltungsanordnung zur Mittelwertbildung bei der Pulsdichte-D/A- oder -A/D-Umsetzung.

(43) Veröffentlichungstag der Anmeldung:
**11.10.89 Patentblatt 89/41**

(45) Bekanntmachung des Hinweises auf die
Patenterteilung:
**23.12.92 Patentblatt 92/52**

(84) Benannte Vertragsstaaten:
**DE FR GB IT NL**

(56) Entgegenhaltungen:
**WO-A-86/05048**
**US-A- 4 156 871**

**IBM TECHNICAL DISCLOSURE BULLETIN,
Band 10, Nr. 4, September 1967, Seite 370,
New York, US; H. DEUTSCH et al.: "Digital
filter for delta demodulation"**

(73) Patentinhaber: **Deutsche ITT Industries GmbH
Hans-Bunte-Strasse 19 Postfach 840
W-7800 Freiburg i.Br.(DE)**

(72) Erfinder: **Pfeifer, Heinrich, Dipl.-Ing.
Hinterhofstrasse 50
W-7819 Denzlingen(DE)**
Erfinder: **Reich, Werner, Dr.
Kleiststrasse 2a
W-7830 Emmendingen(DE)**
Erfinder: **Theus, Ulrich, Dr.
Schönbergstrasse 5b
W-7803 Gundelfingen(DE)**

**Beschreibung**

Die Erfindung betrifft eine Schaltungsanordnung, die aus einem pulsdichte-moduliertem Signal (= PDM-Signal) ein analoges Signal erzeugt, das dem zeitlichen Mittelwert des PDM-Signals entspricht und somit je nach dem Grad der Glättung bereits eine D/A-Umsetzung des PDM-Signals darstellt. Derartige Schaltungsanordnungen werden insbesondere auch bei Pulsdichte-A/D-Umsetzern mit Sigma-Delta-Modulatoren in deren Rückkopplungsweg verwendet.

Die US-A 4 156 871 zeigt beispielsweise in ihrer Fig. 1 die Schaltung eines Pulsdichte-A/D-Umsetzers, dessen Ausgangssignal, nämlich das PDM-Signal, über einen RC-Tiefpaß zur Mittelwertbildung zurückgeführt ist. Der Kondensator des RC-Tiefpaßes ist ferner über einen Widerstand mit dem Signaleingang für das zu wandelnde Analogsignal verbunden.

In "Elektronik", Nr. 19, 20. September 1985, Seiten 75 bis 77 sind weitere Beispiele von Pulsdichte-A/D- oder -D/A-Umsetzern gezeigt, die Sigma-Delta-Modulatoren und mindestens eine Mittelwertbildung des PDM-Signals mit einem RC-Tiefpaß oder einem Integrator enthalten. Ferner wird beschrieben, daß mittels eines digitalen Pulsdichtemodulators die Umwandlung von pulscodemodulierten Signalen (= PCM-Signale) in PDM-Signale einfach ist und daß andererseits auch auf einfache Weise mittels eines Dezimationsfilters (= digitaler Tiefpaß) aus dem PDM-Signal ein PCM-Signal mit geringerer Abtastrate und dafür höherer Stellenanzahl gebildet werden kann, so daß sich über diese PDM-Zwischenphase eine vorteilhafte D/A- oder A/D-Umsetzung mit hoher Auflösung für übliche PCM-Signale ergibt. Beispielsweise ergibt sich bei einer Audiosignalbandbreite von 15 kHz und einer Taktfrequenz von 4,5 MHz ein theoretischer Signal-zu-Rausch-Abstand von 85 dB und damit eine entsprechende maximal mögliche Auflösung von etwa 14 Stellen bei einem Dualzahlencode.

Die erreichbare Auflösung der PDM-Signale bei der A/D- und der D/A-Umsetzung hängt indessen von der Genauigkeit der Mittelwertbildung ab. Eine besonders störende Fehlerquelle ist dabei das Taktjittern (clock signal jitter), das ein Jittern der PDM-Signalflanken bewirkt, was ein dem Mittelwert überlagertes Rauschsignal erzeugt.

Aus IBM Technical Disclosures Bulletin, Bd. 10, Nr.4, September 1967, Seite 370 ist eine digitale Filteranordnung für eine Delta-Demodulation bekannt, bei der das digitale Signal in Delta-Modulation dem Serieneingang eines Schieberegisters mit n-geradzahligen Schieberegisterstufen zugeführt wird, wobei der Schiebetakt mit dem Datentakt des Delta-Modulationssignals identisch ist. Die n-Schieberegisterstufen bilden nach dem logischen Zustand der jeweiligen Schieberegisterstufe n gleichgewichtete Zustandssignale, die über eine Summiereinrichtung einem Integrator mit nachgeschaltetem Tiefpaßfilter zugeführt sind. Durch die Verwendung des Schieberegisters mit den n-geradzahligen Zustandssignalen werden bei der Demodulation insbesonders unerwünschte Störkomponenten unterdrückt, die ansonsten trotz der Mittelwertbildung bei der halben Abtastfrequenz auftreten.

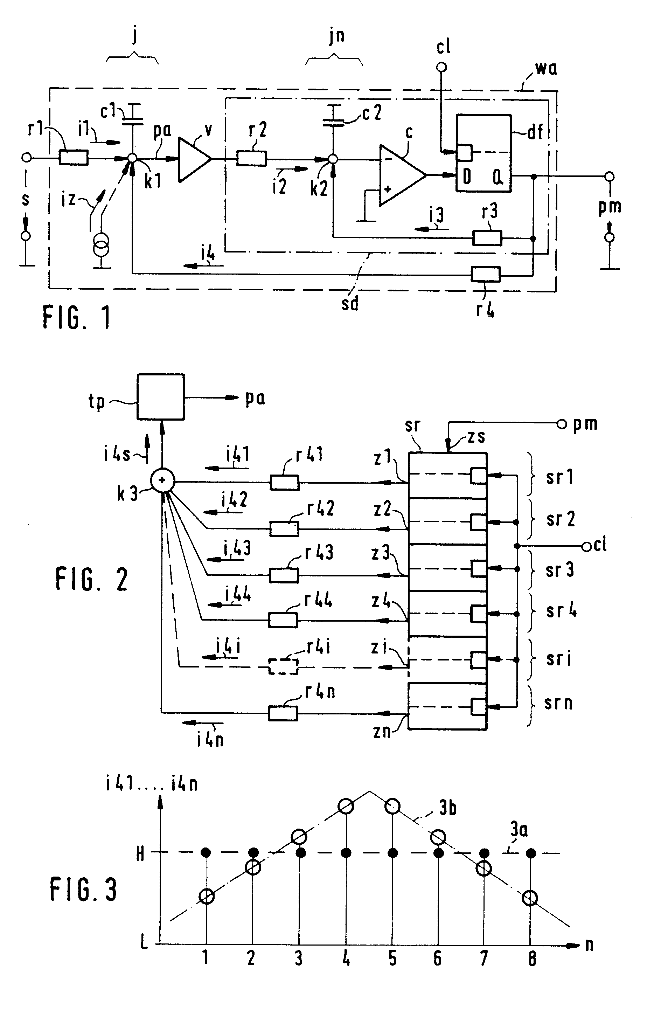

Der wesentliche Gedanke der Mittelwertbildungseinrichtung nach "IBM Technical Disclosure Bulletin", Bd. 10, Nr. 4, September 1967, Seite 370 besteht darin, zusätzlich zur üblichen, zeitlichen Mittelwertbildung, die das PDM-Signal mittels eines Tiefpasses mittelt, eine weitere Mittelwertbildung vorzusehen, die das PDM-Signal innerhalb eines über mehrere Signalwerte mitlaufenden Zeitfensters mittelt, um damit den Beitrag der zeitlich verfälschten PDM-Signalflanken zu Mittelwert zu vermindern. Die weitere Mittelwertbildung erfolgt mittels eines n-stufigen Schieberegisters, dessen Serieneingang mit dem PDM-Signal gespeist ist und an dessen n-stelligem Parallelausgang die Aufeinanderfolge von n PDM-Einzel-Signalzuständen gleichzeitig abgreifbar ist, vgl. Fig. 2. Als Schiebetakt dient das Taktsignal. Der jeweilige binäre Zustand der n Schieberegisterstufen bestimmt dabei den Zustand von n Zustandssignalen, wobei jeder der n Schieberegisterstufen jeweils ein Zustandssignal zugeordnet ist. Ein Summierer bildet aus allen Zustandssignalen ein resultierendes Summensignal, das der zeitlichen Mittelwertbildung zugeführt ist. Die Schaltungsanordnung bleibt jedoch trotzdem kritisch gegenüber unsymmetrischen An- und Abstiegsflanken der Schieberegisterausgangsstufen und kritisch gegenüber verjitterten Schiebetaktsignalen.

Es ist daher Aufgabe der in den Ansprüchen gekennzeichneten Erfindung, eine verbesserte Schaltungsanordnung mit einem Schieberegister zur Mittelwertbildung eines PDM-Signals anzugeben, bei der die Auswirkungen eines verjitterten Schiebetaktes und/oder die Auswirkungen unsymmetrischer Signalflanken der Schieberegisterausgangsstufen auf die Mittelwertbildung erheblich reduziert werden, ohne das Nutzsignal in seinem Frequenzbereich zu ändern.

Der wesentliche Erfindungsgedanke besteht darin, daß die einzelnen Zustandssignale dem Summierer jeweils über eine Torschaltung zugeführt sind, die nur während eines kurzen Zeitintervalls während jedes Schiebetaktes durchlässig ist, und zwar während des eingeschwungenen Zustandes der jeweiligen Schieberegisterstufe. Eine Schieberegisteranordnung mit Mehrphasentaktsteuerung ermöglicht eine besonders vorteilhafte Ausführungsform, weil das Mehrphasentaktsignal auch als Steuertakt für die Torschaltung dient. Neben der einfach zu realisierenden Torschaltung ist dabei ein weiterer Vorteil, daß die zur Verarbeitung erforderliche Taktsignalfrequenz nicht wie beim bekannten "return-to-zero-Verfahren" verdoppelt werden muß, indem hinter jedem Signalzustand eine zusätzliche "Null" eingefügt wird.

Die weitere Mittelwertbildung mittels des Schieberegisters und der Zustandssignale erlaubt die unterschiedliche Gewichtung der einzelnen Zustandssignale. Durch die Art der Gewichtung kann der Frequenzverlauf des Rauschanteils im Nutzsignal vorteilhaft beeinflußt werden, so daß z.B. der Rauschanteil im Nutzfrequenzbereich zu Lasten des dazu außerhalbliegenden Frequenzbereiches zusätzlich abgesenkt wird.

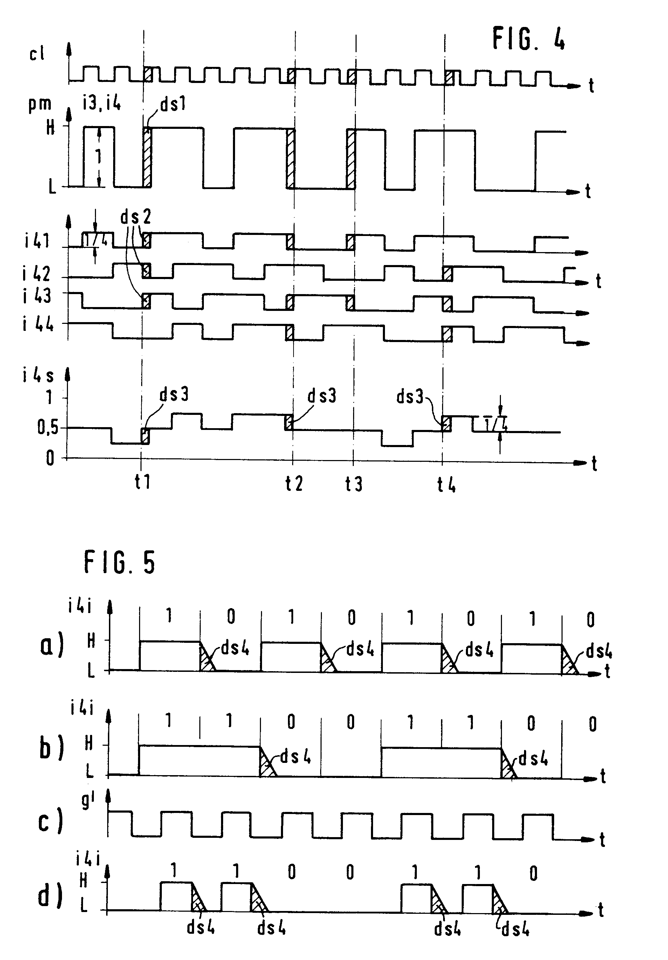

Mit der Torschaltung wird das dem Summierer zugeführte Zustandssignal unabhängig vom Vor- oder Nachzustand "isoliert", ohne daß unterschiedliche An- oder Abstiegsflanken des jeweiligen Zustandssignals den Mittelwert ebenfalls beeinflussen, vgl. Fig. 5.

In der DE-B 27 17 042 (= US-A 4 125 803) ist bei einem D/A-Umsetzer die Verwendung eines Schieberegisters beschrieben, das Teil einer Stromvertielerschaltung ist. Diese liefert eine Anzahl Gleichstrompaare, die sehr genaue und in ganzen Zahlen ausdrückbare Größenverhältnisse aufweisen. Mittels einer vom Schieberegister-Parallelausgang gesteuerten Schalteranordnung wird eine erste bzw. eine zweite Anzahl gleichgroßer Teilströme auf einen ersten bzw. einen zweiten Summenpunkt geschaltet, wobei das Schieberegister die einzelnen Teilströme in gleichen Intervallen zyklisch so umschaltet, daß während eines Zyklusumlaufs alle vorhandenen Teilströme genau gleichoft und damit gleichlang zur Summenbildung beitragen.

Da alle Teilströme durch Teilung einer einzigen Stromquelle entstammen, kompensieren sich die Abweichungen der einzelnen Teilströme jeweils bei jedem ganzen n Takte umfaßenden Zyklusumlauf. Während des Zyklusumlaufs ist das Schieberegister als Ring geschaltet. Der Schiebetakt muß jitterfrei sein. Somit unterscheidet sich diese Schaltungsanordnung wesentlich vom Erfindungsgegenstand.

Die Erfindung wird nun anhand der Figuren der Zeichnung näher erläutert.

Fig. 1 zeigt als Blockschaltbild einen bekannten Pulsdichte-A/D-Umsetzer mit einem Sigma-Delta-Modulator,

Fig. 2 zeigt als Blockschaltbild schematisch ein bekanntes Ausführungsbeispiel der Schaltungsanordung zur Mittelwertbildung mit einem n-stufigen Schieberegister,

Fig. 3 zeigt schematisch ein Beispiel für die Gewichtung der vom Schieberegister abhängigen Zustandssignale,

Fig. 4 zeigt schematisch anhand einiger typischer Signalverläufe, wie eine Schaltungsanordnung nach Fig. 2 den Einfluß des Taktjitterns auf die Mittelwertbildung verringert,

Fig. 5 zeigt schematisch, wie unterschiedliche An- und Abstiegsflanken des PDM-Signals ebenfalls die Mittelwertbildung stören und wie dieser Einfluß nach der Erfindung beseitigt werden kann,

Fig. 6 zeigt schematisch als Blockschaltbild ein Ausführungsbeispiel für mehrphasentaktgesteuerte Schieberegisterstufen mit jeweils zugeordneter Torschaltung,

Fig. 7 zeigt dazu einige typische Signalverläufe,

Fig. 8 zeigt schematisch als Blockschaltbild einen Pulsdichte-A/D-Umsetzer, dessen äußere PDM-Signalrückkopplung als Schaltungsanordnung entsprechend der Erfindung ausgebildet ist,

Fig. 9 zeigt schematisch ein anderes Ausführungsbeispiel der Torschaltung,

Fig. 10 zeigt dazu einige typische Signalverläufe, und

Fig. 11 zeigt schematisch das Schaltbild eines Transkonduktanz-Verstärkers, der aus dem analogen Eingangssignal und dem Summensignal das zu integrierende Differenzsignal erzeugt.

Der in Fig. 1 schematisch dargestellte Pulsdichte-A/D-Umsetzer wa gehört zum Stand der Technik und ist beispielsweise in der oben genannten Zeitschrift "Elektronik" beschrieben. Er wird auch als Sigma-Delta-Modulator zweiter Ordnung bezeichnet, weil er als Mittelwertbildner zwei Tiefpässe erster Ordnung oder zwei Integrierer j, jn erster Ordnung enthält, wobei der Integrierer j der äußeren und der Sigma-Delta-Integrierer jn der inneren PDM-Rückkopplungsschleife zuzurechnen ist. Integrierer höherer Ordnung oder entsprechende Tiefpaß-Filter dürfen in diesen A/D-Umsetzern nicht verwendet werden.

Das zu digitalisierende analoge Eingangssignal s erzeugt über den ersten Widerstand r1 das Zwischensignal i1, nämlich einen Strom, der dem ersten Schaltungsknoten k1 zugeführt ist, an dem ferner der erste Kondensator c1, der Eingang des Verstärkers v und der vierte Widerstand r4 angeschlossen sind, dessen abgewandter Anschluß mit dem Ausgang für das PDM-Signal pm verbunden ist. Mit diesem Anschluß ist der dritte bzw. vierte Widerstand r3, r4 verbunden, der das innere bzw. äußere Rückkopplungssignal i3, i4 bestimmt, das dem zweiten bzw. ersten Schaltungsknoten k2, k1 zugeführt ist. Der zweite Schaltungsknoten k2 ist über den zweiten Widerstand r2 an dem Ausgang des Verstärkers v angeschlossen und ferner mit dem invertierenden Eingang des Komparators c und mit dem zweiten Kondensator c2 verbunden.

Der zweite Widerstand r2 bildet aus der Ausgangsspannung des Verstärkers v den Eingangsstrom i2 des Sigma-Delta-Modulators sd. Somit stellt der erste bzw. zweite Schaltungsknoten k1, k2 in Verbindung mit dem ersten bzw. zweiten Kondensator c1, c2 jeweils einen Integrierer j, jn für die zugeführten Ströme i1, i4 bzw. i2, i3 dar. Dabei findet in dem jeweiligen Schaltungsknoten k1, k2 zwar schaltungsseitig eine Summation der beiden zugeführten Ströme i1 und i4 bzw. i2 und i3 statt, deren Stromrichtung durch schaltungstechnische Maßnahmen jedoch so vorgegeben ist, daß die Summation jeweils eine Differenzbildung bewirkt, so daß die Integration nur den resultierenden Differenzstrom betrifft. Zudem ist durch die Wahl der vier Widerstände r1 bis r4, der Verstärkung des Verstärkers v und der Signalamplituden am Ein- und Ausgang die mittlere Strombilanz in den beiden Schaltungsknoten k1, k2 ausgeglichen.

Der nichtinvertierende Eingang des Komparators c liegt am Bezugspotential und der Ausgang am D-Eingang des D-Flipflops df, dessen Takteingang vom Taktsignal cl gesteuert ist und an dessen Q-Ausgang das PDM-Signal pm abgreifbar ist.

Bezüglich des analogen Eingangssignals s und des PDM-Signals pm stellen der Integrierer j und der Sigma-Delta-Integrierer jn nur angenähert ideale Integrierer dar, denn in beiden Fällen handelt es sich eigentlich um RC-Tiefpässe sehr tiefer Grenzfrequenz - für Audiosignale z.B. kleiner als 5 kHz. Die geforderte Polarität der den beiden Schaltungsknoten k1, k2 zugeführten Signale kann jedoch auch mittels einer anderen Schaltungskonfiguration erreicht werden, z.B. mittels Signalinvertierung am D-Flipflop df oder am Komparator c oder durch die Verwendung invertierender Verstärker.

Obwohl die Grenzfrequenz der RC-Tiefpässe wie angegeben im Nutzfrequenzband liegt, wird der Frequenzgang des Nutzsignals nicht gestört. Denn durch die im zeitlichen Mittel ausgeglichene Strombilanz im ersten und im zweiten Schaltungsknoten k1, k2 stellen diese sehr langsam mitlaufende Potentiale für das eingangsseitige und das rückgekoppelte Signal dar, so daß die angeschlossenen Kondensatoren c1, c2 in erster Näherung im Nutzfrequenzband ohne Einfluß auf den Signalweg sind.

Eine weitere Möglichkeit, um die Strombilanz in den beiden Schaltungsknoten k1, k2 auszugleichen, ist die Zuführung eines Zusatzsignals iz mit zeitlich konstantem Mittelwert das in Fig. 1 gestrichelt dargestellt aus einer Stromquelle dem ersten Schaltungsknoten k1 zugeführt ist. Dies kann z.B. dann erforderlich sein, wenn das analoge Eingangssignal s symmetrisch um das Massepotential liegt, die beiden Zustände des D-Flipflops dagegen unsymmetrisch bezüglich des Massepotentials sind.

Wenn das Taktsignal cl verjittert ist, dann sind auch die Flanken des PDM-Signals verjittert und der Mittelwertbildung oder Integration der rückgeführten PDM-Signale überlagert sich ein jitterbedingtes Rauschsignal. Besonders kritisch ist dabei die Mittelwertbildung in der äußeren Rückkoppelungsschleife. Die innere Rückkopplungsschleife ist nicht so kritisch, weil in ihr nur noch das tiefpaßgefilterte Fehlersignal digitalisiert wird, dessen Beitrag entsprechend klein ist und daher nur geringe Anforderungen an die Genauigkeit stellt. Als Fehlersignal ist der im ersten Schaltungsknoten k1 gebildete Differenzstrom bezeichnet, der in der Regel klein ist. Die Auflösung des PDM-A/D-Umsetzers wa hängt somit wesentlich von der Genauigkeit des im Integrierer j gemittelten Signals pa ab.

In Fig. 2 ist schematisch als Blockschaltbild ein bekanntes Ausführungsbeispiel der Schaltungsanordnung zur Mittelwertbildung des PDM-Signals pm gezeigt. Das Blockschaltbild enthält das n-stufige Schieberegister sr, den Summierer k3 und das Tiefpaß-Filter tp. Die n-Schieberegisterstufen sr1 bis srn sind vom Taktsignal cl gesteuert. Die einzelnen Schieberegisterstufen sind der Einfachheit halber schematisch als Flipflop-Schaltungen dargestellt, sie sind jedoch keineswegs auf diese beschränkt.

Dem Serieneingang zs des Schieberegisters sr ist das PDM-Signal pm zugeführt. Der Parallelausgang besteht aus den einzelnen Schieberegisterstufen-Ausgängen z1 bis zn, an die jeweils ein Teilwiderstand r41 bis r4n angeschlossen ist, der das niederohmige Ausgangspotential der einzelnen Schieberegisterstufen in einen ihrem jeweiligen Zustand entsprechenden Strom umwandelt und somit die n Zustandssignale i41 bis i4n erzeugt. Diese sind auf den Summierer k3 geführt, der im einfachsten Fall ein Schaltungsknoten ist, der die einzelnen zugeführten Ströme zusammenfaßt und als Summensignal i4s an das Tiefpaßfilter tp weiterleitet. Dessen Ausgangssignal ist das gemittelte Signal pa, das bei ausreichender Siebung das rückgewandelte PDM-Signal ist. Der Durchlaßbereich des Tiefpaß-Filters tp, das dabei vorzugsweise ein Tiefpaß-Filter höheren Grades ist, umfaßt bei einem vollständigen PDM-D/A-Umsetzer im Gegensatz zum PDM-A/D-Umsetzer von Fig. 1 mindestens die gesamte Nutzsignalbandbreite.

Das eingangs beschriebene mitlaufende Zeitfenster wird dabei durch die n Schieberegisterstufen sr1 bis srn gebildet, deren n Ausgänge z1 bis zn für die weitere Mittelwertbildung gleichzeitig abgreifbar sind. Wenn die Ausgangspotentiale der n Schieberegisterstufen sr1 bis srn in dem einen bzw. in dem anderen Zustand gleich sind, dann sind bei gleichen Teilwiderständen r41 bis r4n auch die jeweiligen Zustandssignale i41 bis i4n untereinander gleich. Von Vorteil kann jedoch auch eine geeignete Gewichtung sein.

Beispielsweise ist in Fig. 3 für ein achtstufiges Schieberegister ein Gewichtungsverlauf der acht Zustandssignale i41 bis i48 gezeigt, der vom ersten bis zum vierten Zustandssignal i41, i44 linear ansteigt und vom fünften bis zum achten Zustandssignal i45, i48 ebenso linear wieder abfällt, wobei der Wert der beiden mittleren Zustandssignale i44, i45 einander gleich ist. Der Gewichtungsverlauf des H-Pegels ist somit dreiecksförmig, ohne indessen den arithmetischen Mittelwert aller acht Zustandssignale i41 bis i48 zu verändern.

Fig. 4 zeigt an einigen typischen Signalverläufen die grundsätzliche Wirkungsweise der in Fig. 2 dargestellten Schaltungsanordnung. Das Taktsignal cl ist ein Rechtecksignal, mit einem Puls-Pausen-Verhältnis von eins zu eins. Die An- oder Abstiegsflanke des PDM-Signals pm und somit die der beiden Rückkopplungssignale i3, i4 ist mit der Anstiegsflanke des Taktsignals cl gekoppelt. Erscheint diese verfrüht oder verspätet, also verjittert, dann sind auch die zugehörigen Flanken des PDM- und der beiden Rückkopplungssignale pm, i3, i4 verjittert, wie dies in Fig. 4 zu den Zeitpunkten t1, t2 und t3 dargestellt ist. Die verjitterte Taktsignalflanke zum Zeitpunkt t4 wirkt sich auf das PDM-Signal pm nicht aus, weil dieses seinen Zustand zum Zeitpunkt t4 nicht ändert.

Die schraffierten Flächen im PDM-Signal pm, das auf die Amplitude "1" normiert ist, verfälschen somit als erste Fehlerflächen ds1 die Mittelwertbildung. Bei langen Integrationszeiten, z.B. infolge großer Integrations-Zeitkonstanten, mitteln sich diese Fehler zum Teil wieder aus, z.B. kann eine verspätete Anstiegsflanke zum Zeitpunkt t1 eine verfrühte Anstiegsflanke zum Zeitpunkt t3 teilweise kompensieren. Durch die vergrößerte Zeitkonstante kann dann allerdings auch das gemittelte Signal pa (in Fig. 4 nicht dargestellt) keine schnelle Signaländerungen mehr ausführen, so daß dessen maximale obere Grenzfrequenz abgesenkt wird.

Ein in Fig. 4 angenommenes vierstufiges Schieberegister mit vier gleichgewichteten Zustandssignalen i41 bis i44 reduziert bereits deutlich den Einfluß des verjitterten Taktsignals cl. Die vier Zustandssignale i41 bis i44 sind jeweils um einen Takt verzögert in Fig. 4 untereinander gezeichnet. Dabei beträgt die Amplitude der vier Zustandssignale i41 bis i44 jeweils nur ein Viertel der Amplitude des ursprünglichen äußeren Rückkopplungssignals i4, damit das Summensignal i4s am Integrierer j in beiden Fällen des gemittelte Signal pa mit gleicher Größe erzeugt. Die jitterbedingten Fehler der vier Zustandssignale i41 bis i44 sind schraffiert als zweite Fehlerflächen ds2 dargestellt.

In Fig. 4 ist als letztes Zeitdiagramm das Summensignal i4s dargestellt, das sich aus der Addition der vier Zustandssignale i41 bis i44 ergibt. Die verjitterten Taktsignalflanken bewirken am Summensignal i4s ebenfalls verjitterte Signalflanken, deren dritte Fehlerflächen ds3 jeweils nur ein Viertel der ersten Fehlerfläche ds1 des PDM-Signals pm betragen. Denn durch die Addition der vier Zustandssignale i41 bis i44 kompensiert sich z.B. zum Zeitpunkt t1 die Fehlerfläche ds2 des zweiten Zustandssignals i42 mit der gleich großen Fehlerfläche ds2 des ersten oder dritten Zustandssignals i41, i43. Daher bleibt nur eine dieser zweiten Fehlerflächen ds2 übrig, die somit die dritte Fehlerfläche ds3 des Summensignals i4s bildet. Ähnlich entsteht die Fehlerfläche am Summensignal i4s zum Zeitpunkt t2.

Zum Zeitpunkt t3 bleibt das Summensignal i4s konstant, so daß sich das verjitterte Taktisgnal cl überhaupt nicht auswirkt, obwohl das PDM-Signal pm eine verjitterte Anstiegsflanke aufweist. Im Gegensatz dazu findet zum Zeitpunkt t4 während der verjitterten Taktsignalflanke kein Wechsel des PDM-Signals pm statt. Trotzdem weist das Summensignal i4s zu diesem Zeitpunkt einen positiven Signalsprung auf , dessen Wert ein Viertel des Normierungswertes ist und dessen dritte Fehlerfläche ds3 gleich groß wie die zum Zeitpunkt t1 ist. Die vier Zustandssignale i41 bis i44 zeigen, daß zum Zeitpunkt t4 zwei positive Signalflanken einer negativen gegenüberstehen, so daß die eine Signalflanke mit ihrer zweiten Fehlerfläche ds2 übrigbleibt.

Fig. 5 zeigt eine vierte Fehlerfläche ds4, die bei der Mittelwertbildung im Integrator j das gemittelte Signal pa stört. Und zwar ist dies der unterschiedliche Verlauf der An- und der Abstiegsflanken der Zustandssignale i4i. Das Diagramm a) stellt eines der Zustandssignale i4i dar, das mit jeder Taktperiode seinen Zustand wechselt. Zur Verdeutlichung ist dabei die Vorderflanke wesentlich steiler als die Rückflanke dargestellt. Daher wird zum Zeitpunkt der Rückflanke die bei der Integration wirksame Impulsfläche durch die schraffiert dargestellte vierte Fehlerfläche ds4 vergrößert. Diese tritt immer auf, wenn ein Signalwechsel vom H-Pegel zum L-Pegel stattfindet.

So ist beispielsweise der Mittelwert eines Signals nach Fig. 5a, das sich alternierend mit jeder Taktperiode ändert, ein anderer als bei einem Signal nach Fig. 5b, das sich jeweils nach zwei Taktperioden ändert. Im ersten Fall gehen dabei doppelt so viele vierte Fehlerflächen ds4 in die Mittelwertbildung ein wie im zweiten Fall. Anders als bei den drei taktsignalabhängigen Fehlerflächen ds1, ds2, ds3 mitteln sich die flankenabhängigen vierten Fehlerflächen ds4 gegenseitig nie aus.

Eine Isolierung des jeweiligen Signalzustandes nach dem return-to-zero-Verfahren schafft hier Abhilfe, weil während einer Taktperiode das Signal unabhängig vom jeweiligen Signalzustand immer wieder in einen Grundzustand zurückgeschaltet wird. Damit ist die Anzahl der vierten Fehlerflächen ds4 nur noch von der Anzahl der H-Pegel-Zustände und nicht mehr von ihrer Reihenfolge abhängig.

In Fig. 5d sind beispielsweise für sieben Taktperioden die Signalzustände gezeigt, die vier H-Pegel-Zustände und damit vier der vierten Fehlerflächen ds4 aufweisen. Der L-Pegel ist identisch mit dem Pegel der "Isolierung". Die Zeitdauer, in der das Zustandssignal i4i seinen jeweiligen eigenen Signalzustand annimmt, wird durch das Torsignal $g'$ bestimmt, vgl. Diagramm c. Die im Diagramm b) und d) gezeigten Zustandssignale i4i weisen die gleiche Datenfolge auf, indessen wurde im Diagramm d) das Zustandssignal i4i über eine vom Torsignal $g'$ gesteuerte Torschaltung geführt.

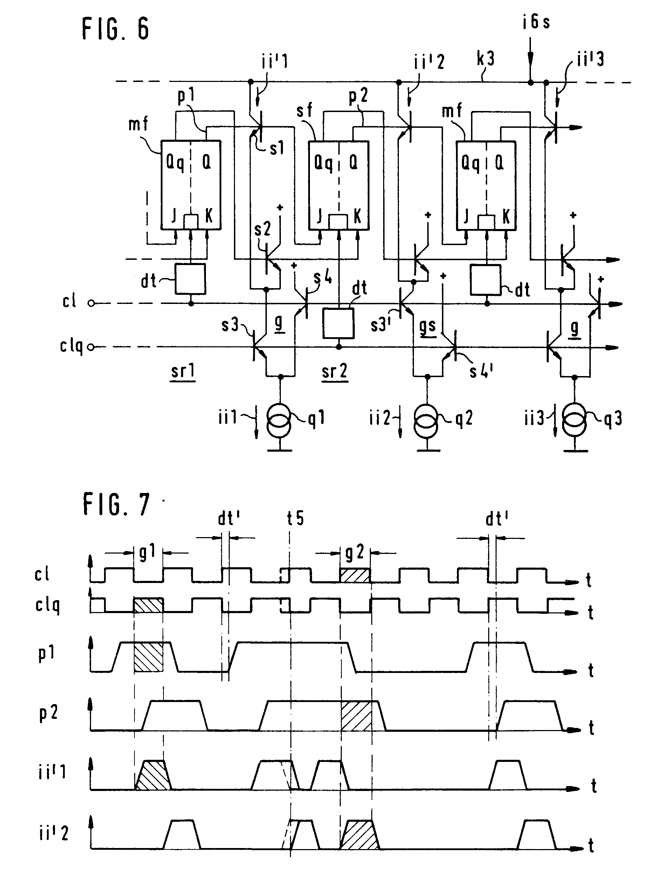

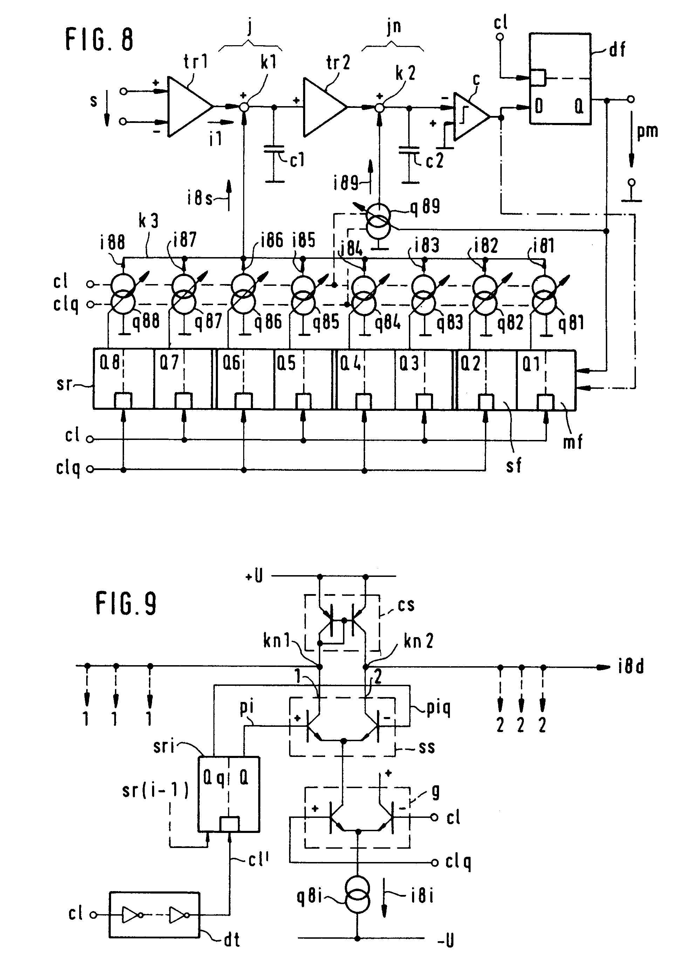

Fig. 6 zeigt ein einfaches Ausführungsbeispiel für diese Torschaltung g, gs. Beim zweiphasentaktgesteuerten Schieberegister, dessen Schieberegisterstufen beispielsweise alternierend mit Master- und Slave-Flipflopstufen mf, sf realisiert sind, kann die jeder Schieberegisterstuffe zugeordnete Torschaltung g, gs mit wenigen zusätzlichen Bauelementen hinzugefügt werden.

Der Q- bzw. Qq-Ausgang der Master-Flipflopstufe mf ist mit der Basis des ersten bzw. zweiten NPN-Transistors s1, s2 verbunden, deren Emitter gemeinsam auf den Kollektor des dritten NPN-Transistors s3 geführt sind. Dessen Basis liegt am invertierten Taktsignal clq und dessen Emitter liegt gemeinsam mit dem Emitter des vierten NPN-Transistors s4 an der nach Masse führenden ersten Stromquelle q1, die den Strom des ersten Zustandssignals ii1 liefert und eigentlich eine Konstantstromsenke ist. Die Basis des vierten NPN-Transistors s4 ist vom Taktsignal cl gesteuert, das ferner über die Verzögerungsschaltung dt am Takteingang der Master-Flipflopstufe mf liegt. Der Kollektor des zweiten bzw. vierten NPN-Transistors s2, s4 ist an ein positives Potential gekoppelt, das je nach Schaltzustand den Strom der ersten Stromquelle q1 übernimmt. Der Kollektor des ersten NPN-Transistors s1 speist den Summierer k3, der in Fig. 6 als Strom-Sammelleitung gezeichnet ist, mit dem durch die Torschaltung g modifizierten ersten Zustandssignal ii'1.

Die an die Slave-Flipflopstufe sf angeschlossene Torschaltung gs ist nahezu gleich aufgebaut wie die oben beschriebene Torschaltung g. Lediglich die Basis des dritten bzw. vierten NPN-Transistors s3', s4' ist vertauscht an das Taktsignal cl bzw. an das invertierte Taktsignal clq angeschlossen. Die zweite Konstantsromquelle q2 liefert dabei den Strom des zweiten Zustandssignals ii2, das über die Torschaltung gs geführt ist und als modifiziertes zweites Zustandssignal ii'2 den Summierer k3 speist. Das Ausgangssignal des Summierers k3 ist das Summensignal i6s.

Die folgende Schieberegisterstufe ist wieder eine Master-Flipflopstufe mf mit der zugehörigen Torschaltung g, die an die dritte Konstantstromquelle q3 angeschlossen, ist um den Strom des dritten Zustandssignals ii3 für das modifizierte dritte Zustandssignal ii'3 zu liefern. Die Gewichtung dieser modifizierten Zustandssignale ii'... erfolgt durch die Einstellung der Stromergiebigkeit der jeweiligen Konstantstromquelle.

Mittels der Verzögerungsschaltung dt wird das jeweilige Schiebetaktsignal etwa um denjenigen Wert innerhalb einer Taktperiode erschoben, der erforderlich ist, um den leitenden Zustand der Torschaltung g, gs im eingeschwungenen Zustand der jeweiligen Schieberegisterstufe zu realisieren.

Die Verzögerungsschaltung dt kann beispielsweise aus einigen hintereinander geschalteten Invertern bestehen. Der genaue Wert der Verzögerung ist unkritisch, die einzelnen Verzögerungszeiten sollten untereinander jedoch gleich sein. Durch diese einfache Maßnahme erübrigt sich die Verwendung eines eigenen Torsignals $g'$, vgl. Fig. 5c.

Die Ausführungsform der Torschaltung g, gs in Fig. 6 ist anhand von NPN-Transistoren als Tor-Schaltelemente gezeigt. Diese sind selbstverständlich auch mittels Feldeffekt-Transistoren realisierbar. Ebenso kann die verwendete Tor-Schaltungsanordnung eine andere sein.

In Fig. 7 sind einige typische Signale der Schaltungsanordnung nach Fig. 6 in ihrem zeitlichen Verlauf dargestellt. Die ersten beiden Diagramme enthalten das Taktsignal cl und das dazu invertierte Taktsignal clq. Ferner ist von der ersten bzw. zweiten Schieberegisterstufe sr1, sr2, nämlich der Master- bzw. Slave-Flipflopstufe mf, sf das jeweilige Ausgangssignal p1, p2 am Q-Ausgang dargestellt. Die Schrägen Signalflanken stellen dabei die erforderlichen Einschwingzeiten für die einzelnen Schieberegisterstufen dar. Infolge der Verzögerungszeiten dt' verschieben sich die An- oder Abstiegsflanken soweit, daß das Taktsignal cl oder das invertierte Taktsignal clq zeitlich mitten im eingeschwungenen Zustand der Ausgangssignale p1, p2 liegt. Durch Schrägschraffur ist der Zeitbereich für die erste oder zweite Torzeit g1, g2 zur Verdeutlichung hervorgehoben. Die beiden zugehörigen modifizierten Zustandssignale ii'1 bzw. ii'2 sind ebenfalls dargestellt.

Diese Art der Torsteuerung ist zudem völlig unempfindlich gegenüber verjitterten gegenphasigen Taktsignalen. Ist z.B. die eine Torzeit durch einen gedehnten Taktsignalimpuls zu lang geraten, so wird die entsprechende Torzeit in der nachfolgenden Schieberegisterstufe zeitlich um den gleichen Differenzbetrag kürzer. Über das Summensignal i6s findet dann der Ausgleich statt. Dieser besondere Vorteil ist in Fig. 7 zum Zeitpunkt t5 dargestellt. Die verzögerte Flanke des gegenphasigen Taktsignals cl, clq bewirkt beim ersten modifizierten bzw. beim zweiten modifizierten Zustandssignal ii′1, ii′2 eine Impulsverlängerung bzw. eine entsprechende Impulsverkürzung, die sich bei der nicht dargestellten Summenbildung somit ohne Rest ausgleichen.

In Fig. 8 ist schematisch als Blockschaltbild ein Pulsdichte-A/D-Umsetzer dargestellt, der als Teilschaltung ein vereinfachtes weiteres Ausführungsbeispiel der Schaltungsanordnung zur Mittelwertbildung von PDM-Signalen enthält. Die Grundstruktur des gesamten A/D-Umsetzers ist ähnlich wie die des Pulsdichte-A/D-Umsetzers wa in Fig. 1. Die äußere Rückkopplungsschleife für das PDM-Signal pm enthält die erfindungsgemäße Schaltungsanordnung zur Mittelwertbildung. Das achtstufige Schieberegister sr besteht aus alternierend hintereinander geschalteten Master- und Slave-Flipflopstufen mf, sf. Der Schiebetakt ist dabei wie in fig. 6 das gegenphasige Taktsignal cl, clq. Die ggf. erforderlichen Verzögerungsschaltungen dt sind nicht dargestellt. Die acht Zustandssignale i81 bis i88 sind durch acht gesteuerte Konstantstromquellen q81 bis q88 gebildet, deren Stromsteuereingang mit dem jeweiligen Q-Ausgang Q1 bis Q8 der zugehörigen Schieberegisterstufe verbunden ist.

Die zu jedem Zustandssignal i81 bis i88 gehörige Torschaltung ist beispielsweise in Fig. 9 für ein Tor gezeigt. Die zugehörigen Torsignale sind die gegenphasigen Taktsignale cl, clq, die in Fig. 8 in vereinfachter Darstellung den gesteuerten Konstantstromquellen q81 bis q88 als zwei Steuersignale zugeführt sind. Der Summierer k3 ist die Strom-Sammelschiene für die acht Zustandssignale i81 bis i88, die zusammen als das Summensignal i8s dem ersten Schaltungsknoten k1 zugeführt sind. Dieser ist ferner mit dem Zwischensignal i1 gespeist, das der erste Transkonduktanz-Verstärker tr1 aus dem analogen Eingangssignal s erzeugt.

Der Integrierer j, der den ersten Kondensator c1 enthält, zeigt ideales Integrierverhalten, denn seine Ansteuerung erfolgt allein über hochohmige Stromquellen. Die am ersten Kondensator c1 abgreifbare Ausgangsspannung des Integrieres j wird mittels des zweiten Transkonduktanz-Verstärkers tr2 ebenfalls direkt proportional in einen Strom umgewandelt, der dem zweiten Schaltungsknoten k2 zugeführt ist. Dieser ist ferner mit dem Ausgangsstrom i89 der neunten gesteuerten Konstantstromquelle q89 gespeist, deren Steuereingang das PDM-Signal pm zugeführt ist.

Am zweiten Schaltungsknoten k2 ist der zweite Kondensator c2 und der negative Eingang des Komparators c, dessen positiver Eingang auf dem Masse-Bezugspotential liegt, angeschlossen. Somit stellt auch der Sigma-Delta-Integrierer jn ebenfalls einen Integrierer mit idealen Eigenschaften dar, weil er nur über hochohmige Stromquellen gespeist ist.

Der Ausgang des Komparators c speist wie in Fig. 1 den D-Eingang des D-Flipflops df, an dessen Q-Ausgang das PDM-Signal pm abgreifbar ist und an dessen Takteingang das nichtinvertierte Taktsignal cl angeschlossen ist. Da der Ausgang des Komparators c eigentlich schon das PDM-Signal liefert, kann das Schieberegister sr statt an den Ausgang des D-Flipflops df auch an den Ausgang des Komparators c angeschlossen werden. Dies ist in Fig. 8 mittels der strichpunktierten Linie dargestellt. Dabei wird die Mittelwertbildung im Schieberegister sr vorteilhaft um einen Takt vorverlegt. Diese Maßnahme erlaubt zudem eine Vereinfachung der Schaltungsanordnung, denn die Funktion des D-Flipflop df kann dann von der ersten Schieberegisterstufe übernommen werden, indem deren Q-Ausgang Q1 das innere Rückkopplungssignal i89 steuert und ferner das Ausgangs-PDM-Signal pm bildet.

Fig. 9 zeigt das Schaltbild eines Ausführungsbeispiels einer der gesteuerten Konstantstromquellen nach Fig. 8. Das jeweilige Zustandssignal i8... ist dabei ein Strom der drei unterschiedliche Pegel annehmen kann: einen positiven und gleichgroßen negativen Pegel, sowie einen Pegel mit dem Wert 0. Dies wird mittels der abgebildeten Differenzstrom-Erzeugungsschaltung realisiert.

Eine der Schieberegisterstufen sri ist mit dem verzögerten Taktsignal cl′ getaktet. Das Taktsignal cl ist dabei mittels einiger hintereinandergeschalteter Inverter in der Verzögerungsschaltung dt verzögert. Der jeweilige Zustand der Schieberegisterstufen sri ist dabei von der vorausgehenden Schieberegisterstufe sr(i-1) gesteuert, dies ist durch die gestrichelte Signalzuführung auf den Eingang der Schieberegisterstufe sri dargestellt. Der Q- bzw. Qq-Ausgang steuert mit seinem nichtinvertierten bzw. invertierten Ausgangssignal pi, piq den positiven bzw. negativen Eingang der Differenzschaltstufe ss an, die aus zwei emittergekoppelten NPN-Transistoren besteht.

Die beiden Emitter der Differenzschaltstufe ss sind gemeinsam auf den Ausgang der Torschaltung g geführt, die ebenfalls eine aus zwei emittergekoppelten npn-Transistoren bestehende Differenzschaltstufe enthält. Dem negativen bzw. positiven Eingang ist dabei das Taktsignal cl bzw. das gegenphasige Taktsignal clq zugeführt. Ist letzteres Signal positiv, dann ist die Torschaltung g leitend und die an den beiden gemeinsamen Emittern der Torschaltung g angeschlossene Konstantstromquelle q8i liefert ihren Strom i8i an den Ausgang der Torschaltung g.

Entsprechend der dargestellten Ausführungsform mit NPN-Transistoren, handelt es sich bei der Konstantstromquelle q8i eigentlich um eine Konstantstromsenke. Der Ausgang der Torschaltung g ist der Kollektor desjenigen Schalttransistors, dessen Basis mit dem gegenphasigen Taktsignal clq gespeist ist. Der Kollektor des anderen Schalttransistors ist mit der positiven Versorgungsleitung +U gekoppelt und stellt somit im gesperrten Zustand der Torschaltung g die notwendige leitende Verbindung der Kostantstromquelle q8i mit einem positiven Potential her.

Die Differenzschaltstufe ss kann auch als elektronischer Umschalter betrachtet werden, dessen Schaltzunge mit dem Ausgang der Torschaltung g und dessen erster bzw. zweiter Ausgang 1, 2 mit der Schaltzunge verbunden ist, wenn der Q- bzw. Qq-Ausgang der zugehörigen Flipflopstufe sri positiver als deren Qq- bzw. Q-Ausgang ist.

Der erste bzw. zweite Ausgang 1, 2 der Differenzschaltstufe ss ist über den ersten bzw. zweiten Knoten kn1, kn2 mit dem Eingang des Stromspiegels cs bzw. dessen Ausgang verbunden. Der Stromspiegel cs ist als einfache aus zwei PNP-Transistoren bestehende Stromspiegelschaltung dargestellt, deren Emitter mit der positiven Versorgungsleitung +U verbunden sind und deren Basisanschlüsse gemeinsam am Kollektor des einen PNP-Transistors liegen und mit diesem den Eingang des Stromspiegels cs bilden. Der Kollektor des anderen PNP-Transistors bildet den Ausgang des Stromspiegels.

Anstatt jeder Schieberegisterstufe sri einen eigenen Stromspiegel cs zuzuordnen, ist es besser, für alle Schieberegisterstufen sri nur einen einzigen Stromspiegel cs vorzusehen. Die Summierung der Ströme aller erster bzw. zweiter Ausgänge 1, 2 aller Differenzschaltstufen ss findet dabei im ersten bzw. zweiten Knoten kn1, kn2 statt, so daß der gesamte resultierende Differenzstrom i8d am zweiten Knoten kn2 abzunehmen ist. Die Anforderungen an den Stromspiegel cs werden somit durch die vorausgehende Summierung und damit Mittelwertbildung reduziert, weil statt der vollen PDM-Signalsprünge nur der sich wesentlich gemächlicher ändernde Mittelwert dem Stromspiegel cs zugeführt ist.

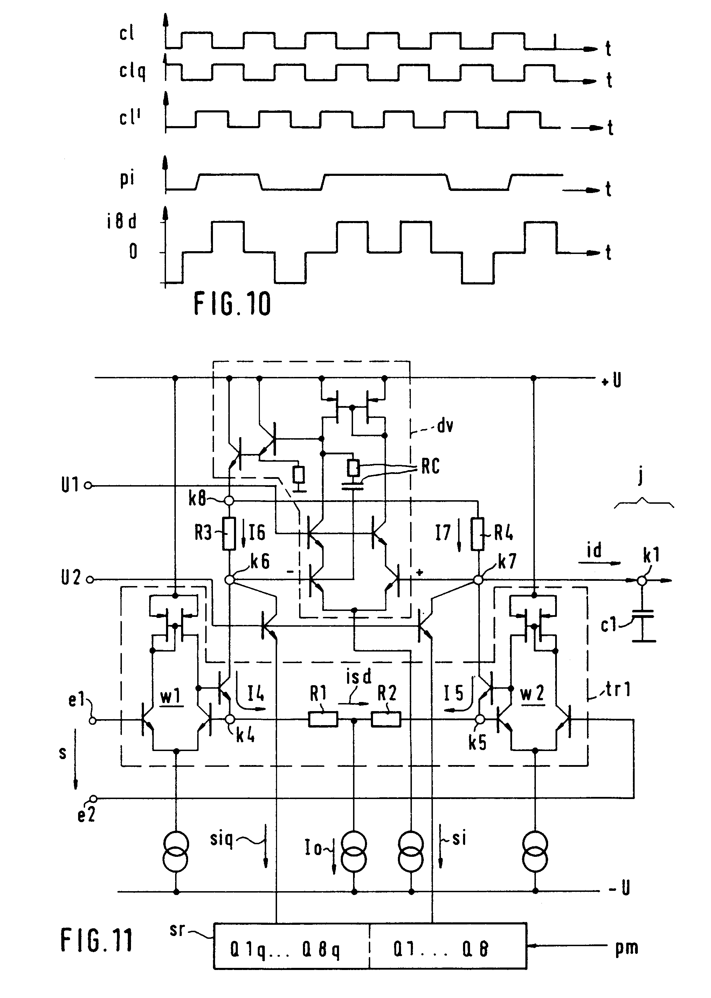

Fig. 10 zeigt als Zeitdiagramm einige typische Signalverläufe der Schaltungsanordnung nach Fig. 9. Die ersten beiden Diagramme stellen das Taktsignal cl und das zugehörige invertierte oder gegenphasige Taktsignal clq untereinander dar. Das dargestellte Puls-Pausen-Verhältnis von 1:1 eignet sich beispielsweise für taktzustandsgesteuerte Schieberegisterstufen. Andere nicht dargestellte Taktsigale, z.B. mehrphasige sich nicht überlappende Taktsignale, werden verwendet, wo flankengesteuerte oder dynamische Schieberegisterstufen Verwendung finden.

In Fig. 10 ist ferner das verzögerte Taktsignal cl′ gezeigt, dessen Anstiegsflanke ggf. den Zustand der jeweiligen Schieberegisterstufe an ihrem Ausgang ändert. Das nichtinvertierte Ausgangssignal pi des Q-Ausgangs ist für einige Taktfolgen als weiteres Diagramm mit einer angenommenen Signalfolge dargestellt. Schließlich ist der zugehörige Differenzstrom i8d für eine einzige Torschaltung g gezeigt. Dieser enthält in zeitlicher Folge je nach dem Zustand der Schieberegisterstufe positive oder gleich große negative Stromimpulse, wobei die Stromflußzeit in allen Fällen gleichlang ist. Da der leitende Zustand der Torschaltung g durch den niederen Pegel des Taktsignals cl bzw. durch den hohen Pegel des gegenphasigen Taktsignals clq gesteuert ist, ist auch der Impulsbeginn des Differenzstroms i8d und dessen Dauer synchron zu diesen Taktsignal-Phasen.

Fig. 11 zeigt eine besonders vorteilhafte Weiterbildung der erfindungsgemäßen Schaltungsanordnung, in der der erste Transkonduktanz-Verstärker tr1 gemeinsam mit weiteren Teilschaltungen sowohl das Zwischensignal als auch das Summensignal als Differenzsignale verarbeitet und daraus ein resultierendes Differenzsignal zur Ansteuerung des Integrierers j erzeugt.

Das zu wandelnde analoge Eingangssignal s ist als Differenzsignal der ersten bzw. zweiten Eingangsklemme e1, e2 der ersten bzw. zweiten Transkonduktanz-Stufe w1, w2 zugeführt, die wie einfache Impedanzwandler aufgebaut sind. Die Transkonduktanz-Stufen w1, w2 enthalten wie die Impedanzwandler einen niederohmigen NPN-Emitterfolgerausgang, über den mittels der Widerstände R1, R2 die Steilheit einstellbar ist. Der Kollektoranschluß des NPN-Emitterfolgers stellt den hochohmigen Stromsenken-Ausgang k6, k7 der Transkondukanz-Stufe w1, w2 dar und ist nicht wie beim Impedanzwandler auf die positive Versorgungsquelle geschaltet. Durch die hohe innere Gegenkopplung der Impedanzwandler-Anordnung sind die Transkonduktanz-Stufen w1, w2 besonders klirrarm. Ferner geht bei konstantem alpha-Stromverstärkungsfaktor der NPN-Emitterfolger dessen endlicher Wert nur als feste Größe in die Steilheit ein.

Der hochohmige Differenzausgang des ersten Transkonduktanz-Verstärkers tr1 ist durch die erste bzw. zweite hochohmige Ausgangsklemme k6, k7 der ersten bzw. zweiten Transkonduktanz-Stufe w1, w2 gebildet, die den ersten bzw. zweiten Ausgangsstrom I4, I5 liefert. Die Differenz dieser beiden Ströme I4, I5 ist direkt proportional zum analogen Eingangssignal s. Diese Proportionalität wird durch die Reihenschaltung von zwei gleichen ohmschen Widerständen R1, R2 erreicht, die die niederohmige erste bzw. zweite Ausgangsklemmen k4, k5 der ersten bzw. zweiten Transkonduktanz-Stufe w1, w2 miteinander verbinden. Das Potential der ersten bzw. zweiten Ausgangsklemme k4, k5 ist dabei identisch mit dem Potential der ersten bzw. zweiten Eingangsklemme e1, e2. Der gemeinsame Verbindungspunkt beider Widerstände R1, R2 ist über eine den Konstantstrom Io ziehende Stromsenke mit der negativen Versorgungsleitung -U verbunden.

Das analoge Eingangssignal s erzeugt zwischen der ersten und zweiten niederohmigen Ausgangsklemme k4, k5 einen Eingangs-Differenzstrom isd, der sowohl von der Größe des analogen Eingangssignals s als auch der Größe der beiden Widerstände R1, R2 abhängig ist.

Liegt an der ersten Eingangsklemme e1 ein höheres Potential als an der zweiten Eingangsklemme e2, dann ist der erste Klemmenstrom I4 an der ersten hochohmigen Ausgangsklemme k6 gleich dem halben Konstantstrom Io vergrößert um den Wert dieses Eingangs-Differenzstroms isd. Entsprechend ist der zweite Klemmenstrom I5 verkleinert; der halbe Konstantstrom Io ist dort um den Eingangs-Differenzstrom isd vermindert.

Die erste bzw. zweite hochohmige Ausgangsklemme k6, k7 stellen dabei in der dargestellten Schaltung Stromsenken-Anschlüsse für den ersten bzw. zweiten Klemmenstrom I4, I5 dar. In der Form weiterer Stromsenken sind an die erste bzw. zweite hochohmige Ausgangsklemme k6, k7 die Zuleitungen für das invertierte bzw. nichtinvertierte Summensignal siq, si angeschlossen, das jeweils vom Potential an den invertierenden bzw. nichtinvertierenden Ausgängen Q1q... Q8q, Q1... Q8 der angenommenen acht Schieberegisterstufen abhängig ist.

Die Erzeugung des nichtinvertierten bzw. invertierten Summensignals si, siq kann dabei ähnlich erfolgen wie bei der Schaltungsanordnung nach Fig. 6. Dabei sind lediglich alle mit den Qq-Ausgängen der Schieberegisterstufen verbundene zweite NPN-Transistoren s2 mit ihren Kollektoren auf eine weitere Strom-Sammelschiene zu schalten, und nicht wie in Fig. 6 gezeigt auf ein positives Bezugspotential. Dem Strom auf der weiteren Strom-Sammelschiene entspricht in Fig. 11 das invertierte Summensignal siq und dem Summensignal i6s in Fig. 6 entspricht in Fig. 11 das nichtinvertierte Summensignal si.

Die Erzeugung des resultierenden Differenzstroms, der durch Differenzbildung aus den Strömen der ersten und zweiten hochohmigen Ausgangsklemme k6, k7 gebildet wird, wäre an sich durch eine PNP-Stromspiegelschaltung ähnlich wie in Fig. 9 leicht realisierbar, wenn die Grenzfrequenz und Stromergiebigkeit von PNP-Transistoren ausreichend wäre. Beides ist in der Regel nicht der Fall, obgleich vor der Stromspiegelung eine Mittelung und eine Differenzbildung der Ströme stattfindet, was die Anforderungen reduziert.

Als Ausweg zeigt Fig. 11 eine Regelschaltung mit dem Differenzverstärke dv, dessen niederohmige Ausgangsklemme k8 die erste und zweite hochohmige Ausgangsklemme k6, k7 mit jeweils zueinander gleichem Quellenstrom I6, I7 speist. Die Gleichheit der beiden Quellenströme I6, I7 wird dadurch erreicht, daß die Stromgleichheit durch zwei gleich Stromquellen-Widerstände R3, R4 mit jeweils gleichem Spannungsabfall erzwungen wird. Dies wird dadurch realisiert, daß die niederohmige Ausgangsklemme k8 des Differenzverstärkers dv über den ersten bzw. zweiten Stromquellen-Widerstand R3, R4 an die erste bzw. zweite hochohmige Ausgangsklemme k6, k7 angeschlossen ist.

Der gleich Spannungsabfall über diesen beiden Stromquellen-Widerstänen R3, R4 wird mittels des Spannungsregelkreises erreicht, dessen wesentlicher Bestandteil der Differenzverstärker dv ist. Dessen invertierender Eingang ist mit der ersten hochohmigen Ausgangsklemme k6 und dessen nichtinvertierender Eingang mit der zweiten hochohmigen Ausgangsklemme k7 verbunden. Eine Differenzspannung am Eingang des Differenzverstärkers dv bewirkt, daß dessen Ausgangsklemme k8 in ihrem Potential solange nachgeregelt wird, bis die Differenz am Eingang des Differenzverstärkers dv ausgeregelt ist. Regelschwingungen verhindert das RC-Dämpfungsglied RC im Regelkreis.

Für den ausgeregelten Zustand gilt, daß der erste Quellenstrom I6 gleich groß wie die Summe aus dem ersten Klemmenstrom I4 und dem Strom des invertierten Summensignals siq ist. Für den resultierenden Differenzstrom id an der hochohmigen Ausgangsklemme k7 gilt dabei, daß er genau die Stromdifferenz ist, die aus dem zweiten Quellensrom I7 und der Stromsumme gebildet wird, dei den zweiten Klemmenstrom I5 und den Strom des nichtinvertierten Summensignals si addiert. Somit ist der resultierende Differenzstrom id genau gleich groß wie der Eingangs-Differenzstrom isd. Über den ersten Schaltungsknoten k1 ist der resultierende Differenzstrom id dem ersten Kondensator c1 zugeführt, der als Integrierer j wirksam ist.

Damit die niederohmige Ausgangsklemme k8 des Differenzverstärkers dv auch schnelle Schwankungen des resultierenden Differenzstroms id realisieren kann, sind die üblichen PNP-Transistoren durch p-Kanal-Feldeffekttransistoren ersetzt. Diese erlauben schnelle als aktive Last geschaltete Stromspiegelschaltungen, die für hohe Verstärkung sorgen. Der hochohmige Ausgang der aktiven Last liegt am Eingang zweier in Serie geschalteter NPN-Emitterfolger, deren niederohmiger Ausgang mit der Ausgangsklemme k8 verbunden ist.

Der Anschluß des Differenzverstärker-Transistorpaars an die aktive Last erfolgt über zwei als Kaskode dienende NPN-Transistoren, deren Basen gemeisam an ein erstes Festpotential U1 angeschlossen sind. Ein zweites Festpotential U2 dient dem Basisanschluß von zwei weiteren NPN-Kaskode-Transistoren, über die das invertierte bzw.

nichtinvertierte Summensignal siq, si der ersten bzw. zweiten hochohmigen Ausgangsklemme k6, k7 zugeführt ist.

In Fig. 11 sind besonders einfache Ausführungsbeispiele für die Realisierung der ersten und der dazu gleichen zweiten Transkonduktanz-Stufe w1, w2 dargestellt. Diese enthalten im Eingang eine Differenzstufe aus einem ersten und einem zweiten NPN-Transistor, deren Emitter gemeinsam über eine Stromquelle mit der negativen Versorgungsleitung -U verbunden sind. Die Basis des ersten NPN-Transistors ist mit der ersten bzw. zweiten Eingangsklemme e1, e2 und die Basis des zweiten NPN-Transistors ist mit der niederohmigen ersten bzw. zweiten Ausgangsklemme k4, k5 verbunden, die durch den Emitter eines dritten NPN-Transistors gebildet wird, der als Emitterfolger geschaltet ist.

Die erforderliche hohe Verstärkung innerhalb der beiden Transkonduktanz-Stufen w1, w2 wird wie beim Differenzverstärker dv ebenfalls durch eine p-Kanal-Stromspiegelschaltung erreicht, die als aktive Last geschaltet ist. Ihr Eingang ist mit dem Kollektor des ersten NPN-Transistors und ihr Ausgang ist mit dem Kollektor des zweiten NPN-Transistors und mit der Basis des dritten NPN-Transistors verbunden. Der Emitter des dritten NPN-Transistors bildet somit die niederohmige erste bzw. zweite Ausgangsklemme k4, k5 die auf dem gleichen Potential wie die erste bzw. zweite Eingangsklemme e1, e2 liegt, während die hochohmige erste bzw. zweite Ausgangsklemme k6, k7 jeweils durch den Kollektor des dritten NPN-Transistors gebildet ist. Der Source-Anschluß der beiden p-Kanal-Transistoren ist gemeinsam auf die positive Versorgungsleitung +U geführt.

**Patentansprüche**

1. Schaltungsanordnung zur Mittelwertbildung bei der Pulsdichte-D/A- oder -A/D-Umsetzung
    - mit einem n-stufigen Schieberegister (sr), dessen Serieneingang (zs) ein pulsdichtemoduliertes Signal (= PDM-Signal) (pm) und dessen Takteingang ein Taktsignal (cl; cl, clq; cl') zugeführt ist,
    - mit einem Summierer (k3), der am Eingang mit n Zustandssignalen (i4...; ii'...; i8....; i8d) gespeist ist, die jeweils einer der n Schieberegisterstufen (sr...; mf, sf) zugeordnet sowie von deren jeweiligem logischen Zustand bedingt sind, und
    - mit einem Tiefpaß-Filter (tp), dessen Eingang mit dem Ausgang des Summierers (k3) gekoppelt ist und an dessen Ausgang das gemittelte Signal (pa) abzunehmen ist,

    dadurch gekennzeichnet,

    daß die n Zustandssignale (i4...; ii'...; i8...; i8d) dem Summierer (k3) jeweils über eine Torschaltung (g; g, gs) als Einzelimpulse zugeführt sind und daß die jeweiligen Toröffnungszeiten (g1, g2) im eingeschwungenen Zustand der zugehörigen Schieberegisterstufe (sr...; mf, sf) liegen und untereinander gleich sind.

2. Schaltungsanordnung nach Anspruch 1 für einen PDM-A/D-Umsetzer (wa), bei dem das Tiefpaß-Filter (tp) ein Integrierer (j) erster Ordnung oder ein gleichwirkender Tiefpaß erster Ordnung ist,
    - mit einem Sigma-Delta-Modulator (sd), dessen Ausgang mit dem Serieneingang (zs) verbunden ist und dessen Eingang mit dem Ausgang des Integrierers (j) gekoppelt ist, und
    - mit einem aus einem analogen Eingangssignal (s) erzeugten Zwischensignal (i1), das den Eingang des Integrieres (j) zusammen mit dem Summensignal (i4s; i6s; i8s; si, siq) speist, wobei der zeitlich gemittelte Wert des Summensignals (i4s; i6s; i8s; si, siq) mittels der Dimensionierung und Polaritätsrichtung des PDM-A/D-Umsetzers (wa) entgegengesetzt gleich dem zeitlich gemittelten Wert des Zwischensignals (i1) einzustellen ist.

3. Schaltungsanordnung nach Anspruch 1 oder 2, bei der dem Eingang des Tiefpaß-Filters (tp) ein Zusatzsignal (iz) zugeführt ist, dessen zeitlicher Mittelwert konstant ist.

4. Schaltungsanordnung nach einem der Ansprüche 1 bis 3 mit untereinander gleichgewichteten Zustandssignalen (i4...; ii'...; i8...; i8d).

5. Schaltungsanordnung nach einem der Ansprüche 1 bis 3 mit derart unterschiedlich gewichteten Zustandssignalen (i4...; ii'...; i8...; i8d), daß der arithmetische Mittelwert der n in gleichem Zustand befindlichen Zustandssignale gleich dem Wert des gleichgewichteten Zustandssignals ist.

6. Schaltungsanordnung nach Anspruch 5 mit einem zum mittleren oder den beiden mittleren Zustandssignalen symmetrisch linear ansteigenden und linear wieder abfallenden Gewichtungsverlauf der n Zustandssignale (i4...; ii'...; i8; i8d).

7. Schaltungsanordnung nach Anspruch 1, bei der das n-stufige Schieberegister (sr) an einem Mehrphasen-Taktsignal (cl, clq) betrieben ist, das der jeweiligen Schieberegisterstufe (mf, sf) vorzugsweise mittels einer Verzögerungsschaltung (dt) um einen Taktbruchteil verzögert zugeführt ist, und bei der das Mehrphasen-Taktsignal (cl, clq) der Torsteuerung dient.

8. Schaltungsanordnung nach Anspruch 7, bei der jedes der n Zustandssignale (i4...; ii'...; i8...; i8d) bei durchgeschalteter Torschaltung (g; g, gs) im ersten bzw. zweiten Zustand der jeweiligen Schieberegisterstufe (sr...; mf, sf) einen positiven bzw. betragsgleichen negativen Wert und bei gesperrter Torschaltung (g; g, gs) den Wert null annimmt.

9. Schaltungsanordnung nach einem der Ansprüche 2 bis 6 mit einem ersten Transkonduktanz-Verstärker (tr1), der aus dem analogen Eingangssignal (s) das Zwischensignal (i1) erzeugt, und/oder mit einem zweiten Transkonduktanz-Verstärker (tr2), der aus dem Ausgangssignal des Integrieres (j) das Eingangssignal des Sigma-Delta-Modulators (sd) erzeugt.

10. Schaltungsanordnung nach Anspruch 9 mit folgenden Merkmalen:
   - der erste Transkonduktanz-Verstärker (tr1) liefert über eine erste bzw. eine zweite hochohmige Ausgangsklemme (k6, k7) einen ersten bzw. einen zweiten Klemmenstrom (I4, I5), deren Differenz direkt proportional zum analogen Eingangssignal (s) ist,
   - über die erste bzw. zweite hochohmige Ausgangsklemme (k6, k7) fließt ferner der Strom eines invertierten bzw. nichtinvertierten Summensignals (siq, si), das vom Zustand der invertierenden bzw. nichtinvertierenden Ausgänge (Q1q...Q8q; Q1, ...Q8) der Schieberegisterstufen abhängig ist,
   - die erste bzw. zweite hochohmige Ausgangsklemme (k6, k7) ist an den invertierenden bzw. nichtinvertierenden Eingang eines Differenzverstärkers (dv) und an einen ersten bzw. einen dazu gleichen zweiten Stromquellen-Widerstand (R3, R4) angeschlossen, deren abgewandte Anschlüsse gemeinsam mit einer niederohmigen Ausgangsklemme (k8) des Differenzverstärkers (dv) verbunden sind, und
   - die zweite hochohmige Ausgangsklemme (k7) ist ferner mit dem Eingang des Integrierers (j) gekoppelt, um diesen mit einem resultierenden Differenzstrom (id) zu speisen.

## Claims

1. A circuit arrangement for averaging signals during pulse-density D/A or A/D conversion, comprising
   - an n-stage shift register (sr) whose serial input (zs) is fed with a pulse-density-modulated signal (= PDM signal) (pm) and whose clock input is fed with a clock signal (cl; cl, clq; cl'),
   - a summer (k3) fed with n state signals (i4...; ii'...; i8...; i8d) each of which is assigned to, and dependent on the logic state of, one of the n shift-register stages (sr...; mf, sf), and
   - a low-pass filter (tp) having its input connected to the output of the summer (k3) and providing the averaged signal (pa) at its output,
   characterized in
   that the n state signals (i4...; ii'...; i8...; i8d) are fed as single pulses to the summer (k3) through one gate circuit (g; g, gs) each, and that the respective ON times (g1, g2) of the gates lie in the steady state of the associated shift-register stage (sr...; mf, sf) and are equal to one another.

2. A circuit arrangement as claimed in claim 1, for a PDM A/D converter (wa) wherein the low-pass filter (tp) is a first-order integrator (j) or a similarly acting first-order low-pass filter, said circuit arrangement comprising
   - a sigma-delta modulator (sd) having its output coupled to the serial input (zs) and having its input connected to the output of the integrator (j), and
   - an intermediate signal (i1) derived from an analog input signal (s) and feeding the input of the integrator (j) together with the sum signal (i4s; i6s; i8s; si, siq), with the time average of the value of the sum signal (i4s; i6s; i8s; si, siq) having to be set oppositely equal to the time average of the value of the intermediate signal (i1) by appropriate selection of the component values and polarity of the PDM A/D converter (wa).

3. A circuit arrangement as claimed in claim 1 or 2 wherein an additional signal (iz) whose time average is constant is applied to the input of the low-pass filter (tp).

4. A circuit arrangement as claimed in any one of claims 1 to 3 with equal-weight state signals (i4...; ii'...; i8...; i8d).

5. A circuit arrangement as claimed in any one of claims 1 to 3 with state signals (i4...; ii'...; i8...; i8d) weighted differently in such a manner that the arithmetic mean of the n state signals which are in the same state is equal to the value of the equal-weight state signal.

6. A circuit arrangement as claimed in claim 5 wherein the weighting characteristic of the n state signals (i4...; ii'...; i8...; i8d) rises and falls linearly and symmetrically with respect to the middle state signal or the two middle state signals.

7. A circuit arrangement as claimed in claim 1, wherein the n-stage shift register (sr) is operated with a multiphase clock signal (cl, clq) which is applied to the respective shift-register stage (mf, sf), preferably after being delayed by a fraction of the clock period in a delay circuit (dt), and wherein the multiphase clock signal (cl, clq) serves as a gating signal.

8. A circuit arrangement as claimed in claim 7 wherein, when the gate circuit (g; g, gs) is ON, each of the n state signals (i4...; ii'...; i8...; i8d) assumes a positive value in the first state of the respective shift-register stage (sr...; mf, sf) and an equal negative value in the second state of the respective shift-register stage, and wherein, when the gate circuit (g; g, gs) is OFF, each of the n state signals assumes the value 0.

9. A circuit arrangement as claimed in any one of claims 2 to 6, comprising a first transconductance amplifier (tr1) which derives the intermediate signal (i1) from the analog input signal (s), and/or a second transconductance amplifier (tr2) which derives the input signal for the sigma -delta modulator (sd) from the output signal of the integrator (j).

10. A circuit arrangement as claimed in claim 9, with the following features:
    - The first transconductance amplifier (tr1) delivers through a first high-impedance output terminal (k6) and a second high-impedance output terminal (k7) a first terminal current (I4) and a second terminal current (I5), respectively, whose difference is directly proportional to the analog input signal (s);
    - the first and second high-impedance output terminals (k6, k7) are further traversed by the currents of an inverted sum signal (siq) and a noninverted sum signal (si), respectively, which are dependent on the states of the inverting outputs (Q1q...Q8q) and noninverting outputs (Q1...Q8), respectively, of the shift-register stages;
    - the first and second high-impedance output terminals (k6, k7) are connected to the inverting and noninverting inputs, respectively, of a differential amplifier (dv) and to a first current-source resistor (r3) and a second current-source resistor (r4), respectively, which are of the same value and whose other terminals are connected to a low-impedance output terminal (k8) of the differential amplifier (dv), and
    - the second high-impedance output terminal (k7) is also coupled to the input of the integrator (j) for feeding the latter with a resultant differential current (id).

**Revendications**

1. Dispositif de circuit pour établir la moyenne dans un convertisseur D/A ou A/D à densité d'impulsions comprenant :
    - un registre à décalage (sr) à n étages, dont l'entrée série (zs) reçoit un signal modulé par densité d'impulsions ( = signal PDM) (pm) et dont l'entrée d'horloge reçoit un signal d'horlage (cl ; cl, clq ; cl') ;
    - un additionneur (k3), qui est alimenté en entrée avec n signaux d'états (i4... ; ii'... ; i8... ; i8d) qui sont associés respectivement à l'un des n étages du registre à décalage (sr... ; mf, sf) ainsi que forcés à leur état logique respectif ; et
    - un filtre passe-bas (tp), dont l'entrée est reliée à la sortie de l'additionneur (k3) et à la sortie duquel le signal moyenné (pa) est à extraire,

   caractérisé en ce que les n signaux d'état (i4... ; ii'... ; i8... ; i8d) sont fournis à l'additionneur respectivement par l'intermédiaire d'un circuit de porte (g ; g, gs) comme impulsion séparée et que les temps d'ouverture de porte (g1, g2) respectifs sont dans l'état oscillant de l'étage de registre à décalage associé (sr... ; mf, sf) et sont égaux entre eux.

2. Dispositif de circuit suivant la revendication 1 pour un convertisseur A/D à PDM (wa), dans lequel le filtre passe-bas (tp) est un intégrateur (j) du premier ordre ou un filtre passe-bas du premier ordre d'un fonctionnement analogue,
    - comprenant un modulateur en sigma-delta (sd), dont la sortie est reliée à l'entrée série (zs) et dont l'entrée est reliée à la sortie de l'intégrateur (j), et

- ayant un signal intermédiaire (i1) généré à partir d'un signal d'entrée analogique (s), qui alimente l'entrée de l'intégrateur (j) conjointement avec le signal de somme (i4s ; i6s ; i8s ; si, siq), où la valeur moyenne temporelle du signal de somme (i4s ; i6s ; i8s ; si, siq) est à régler au moyen du dimensionnement et du sens de polarité du convertisseur A/D à PDM (wa) de telle manière qu'elle s'oppose exactement à la valeur moyenne temporelle du signal intermédiaire (i1).

3. Dispositif de circuit suivant la revendication 1 ou 2, dans lequel l'entrée du filtre passe-bas (tp) reçoit un signal supplémentaire (iz), dont la valeur moyenne temporelle est constante.

4. Dispositif de circuit suivant l'une des revendications 1 à 3, dans lequel les signaux d'état (i4... ; ii'...; i8... ; i8d) ont des poids égaux entre eux.

5. Dispositif de circuit suivant l'une des revendications 1 à 3, dans lequel les signaux d'état (i4... ; ii'... ; i8... ; i8d) ont des poids différents de telle façon que la moyenne arithmétique des n signaux d'état existant dans le même état est égale à la valeur du signal d'état de poids identique.

6. Dispositif de circuit suivant la revendication 5, dans lequel la progression de poids des n signaux d'état (i4... ; ii'... ; i8 ; i8d) croît linéairement, puis décroît linéairement, symétriquement par rapport au signal d'état moyen ou aux deux signaux d'état moyens.

7. Dispositif de circuit suivant la revendication 1, dans lequel le registre à décalage à n étages (sr) est exploité avec un signal d'horloge à plusieurs phases (cl, clq), qui est fourni à l'étage de registre à décalage (mf, sf) respectif de préférence retardé d'une fraction d'horloge au moyen d'un circuit de retard (dt), et dans lequel le signal d'horloge à plusieurs phases (cl, clq) sert de commande de porte.

8. Dispositif de circuit suivant la revendication 7, dans lequel chacun des n signaux d'état (i4...; ii'... ; i8... ; i8d) d'un circuit de porte connecté (g ; g, gs) prend une valeur positive respectivement négative d'une même quantité dans un premier, respectivement second état de l'étage de registre à décalage correspondant (sr... ; mf, sf) et une valeur nulle pour un circuit de porte bloqué (g ; g, gs).

9. Dispositif de circuit suivant l'une des revendications 2 à 6, dans lequel un premier amplificateur de transconducteur (tr1) génère un signal intermédiaire (i1) à partir du signal d'entrée analogique (s), et/ou un deuxième amplificateur de transconductance (tr2) génère le signal d'entrée du modulateur en Sigma-Delta (sd) à partir du signal de sortie de l'intégrateur (j).

10. Dispositif de circuit suivant la revendication 9, caractérisé en ce que :

- le premier amplificateur de transconductance (tr1) délivre sur une première, respectivement une deuxième borne de sortie de résistance élevée (k6, k7) un premier, respectivement un deuxième courant de borne (I4, I5) dont la différence est directement proportionnelle au signal d'entrée analogique (s) ;

- sur la première, respectivement deuxième borne de résistance élevée (k6, k7) circule de plus le courant d'un signal de somme (siq, si) inversé, respectivement non inversé, qui dépend de l'état de la sortie inverseuse, respectivement non inverseuse (Q1q... Q8q ; Q1... Q8) de l'étage de registre à décalage ;

- la première, respectivement la deuxième borne de sortie de résistance élevée (k6, k7) est reliée à l'entrée inverseuse, respectivement non-inverseuse d'un amplificateur différentiel (dv) et à une première, respectivement une deuxième résistance de source de courant (R3, R4) de plus identique, dont les connexions dérivées sont reliées ensemble à une borne de sortie (k8) de résistance plus élevée de l'amplificateur différentiel (dv) et ;

- la deuxième borne de sortie (k7) de résistance élevée est reliée en outre à l'entrée de l'intégrateur (j) pour alimenter celui-ci avec un courant différentiel résultant (id).

FIG. 1

FIG. 2

FIG. 3

14

FIG. 4

FIG. 5

# FIG. 6

# FIG. 7

FIG. 8

FIG. 9

FIG.10

FIG.11